Europäisches Patentamt

European Patent Office

Office européen des brevets

(19)

(11) **EP 1 202 617 A1**

(12) ## DEMANDE DE BREVET EUROPEEN

(43) Date de publication:
**02.05.2002 Bulletin 2002/18**

(51) Int Cl.⁷: **H05K 9/00**

(21) Numéro de dépôt: **01402720.5**

(22) Date de dépôt: **19.10.2001**

(84) Etats contractants désignés:
**AT BE CH CY DE DK ES FI FR GB GR IE IT LI LU
MC NL PT SE TR**
Etats d'extension désignés:
**AL LT LV MK RO SI**

(30) Priorité: **24.10.2000 FR 0013637**

(71) Demandeur: **Thales
75008 Paris (FR)**

(72) Inventeur: **Henry, Ludovic,
c/o Thales Intellectual Pty.
94117 Arcueil Cedex (FR)**

(74) Mandataire: **Lucas, Laurent Jacques
Thales Intellectual Property,
13, avenue du Président Salvador Allende
94117 Arcueil Cedex (FR)**

(54) **Dispositif de blindage emi/cem rigide pour appareil électronique disposé dans un boitier métallique ou métallisé comportant une ouverture**

(57) Le dispositif de blindage de l'invention s'applique en particulier aux écrans LCD (4) Ce dispositif comporte une grille (1) soudée à un cadre métallique (2), lui-même fixé derrière l'ouverture (5) du boîtier. La grille est tendue sur le cadre et protégée par un film plastique (8).

EP 1 202 617 A1

**Description**

La présente invention se rapporte à un dispositif de blindage EMI/CEM rigide pour appareil électronique disposé dans un boîtier métallique ou métallisé comportant une ouverture.

Les équipements comportant des circuits électroniques, qu'ils soient de type grand public, professionnel ou militaire doivent être blindés du point de vue électromagnétique, soit pour éviter de polluer leur environnement s'ils peuvent émettre des parasites électromagnétiques (compatibilité CEM) soit pour éviter d'être perturbés par des parasites extérieurs s'ils comportent des éléments sensibles à de tels parasites (susceptibilité EMI).

Parmi ces équipements figurent les appareils comportant un écran de visualisation, ce qui est le cas d'un grand nombre d'équipements portables ou embarqués (à bord d'avions, de véhicules terrestres..).S'il est facile de blinder un appareil électronique, en l'enfermant dans un boîtier métallique formant cage de Faraday, il est bien moins aisé de blinder un écran de visualisation, tel qu'un écran LCD, qui constitue une zone de passage facile pour les ondes électromagnétiques.

Une solution connue pour blinder un écran sans trop le masquer optiquement consiste à disposer une fine grille métallique entre deux plaques rigides transparentes (en polycarbonate ou en matière acrylique) et à disposer l'ensemble (appelé aussi "hublot") devant l'écran de visualisation.

Cependant une telle solution est loin d'être satisfaisante pour les trois raisons principales suivantes :

■ L'ensemble écran et hublot a un encombrement important dû à l'épaisseur non négligeable du hublot,

■ Les fils métalliques doivent avoir un diamètre important et un pas relativement faible pour compenser la qualité très médiocre de la continuité du blindage en bordure du hublot, ce qui entraîne une plus grande densité de mailles et donc une augmentation de poids.

■ La diminution du pas des mailles et l'augmentation du diamètre du fil les constituant entraînent également une diminution de la luminosité de l'écran, ce qui est d'autant plus gênant que la tendance actuelle est de réaliser des écrans à haute luminosité, dits de type "'plein soleil", pouvant être vus facilement en plein jour.

La présente invention a pour objet un dispositif de blindage électromagnétique d'un appareil électronique, dont l'effet de blindage soit satisfaisant, et qui, lorsqu'il est devant un écran, ne diminue que très peu la luminosité de l'écran, qui ne soit pas encombrant ni lourd.

Le dispositif de blindage conforme à l'invention, pour un appareillage électronique disposé dans un boîtier métallique ou métallisé comportant une ouverture, comporte une grille métallique fixée à un cadre métallique, ce cadre étant fixé derrière l'ouverture du boîtier. De préférence, cette fixation se fait par soudage. De façon avantageuse, cette grille est tendue lors de sa fixation sur le cadre. Egalement de façon avantageuse, le cadre est contraint lors de la fixation de la grille.

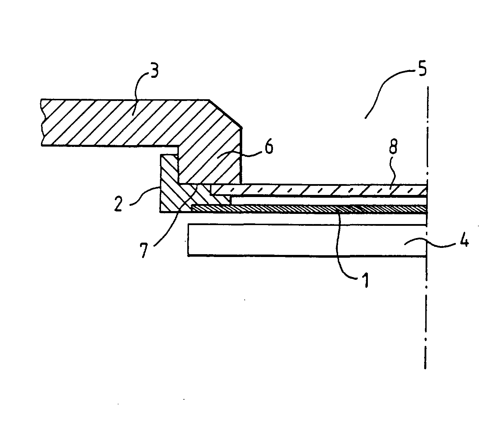

La présente invention sera mieux comprise à la lecture de la description détaillée d'un mode de réalisation, pris à titre d'exemple non limitatif et illustré par le dessin annexé, sur lequel :

- La figure unique est une vue simplifiée, en coupe partielle d'un écran à dalle tactile munie d'un blindage conforme à l'invention.

L'invention est décrite ci-dessous en référence à un écran de visualisation standard (type grand public, dit "COTS" c'est-à-dire "Commercial off the Shelf") mais il est bien entendu qu'elle peut s'appliquer à tous les équipements civils industriels ou militaires disposés dans un coffret métallique comportant une ouverture (destinée par exemple à l'observation depuis l'extérieur, d'un instrument disposé dans le coffret).

On sait que pour déterminer le pas des mailles d'un grillage de blindage, on part de la relation suivante donnant l'efficacité du blindage EB (en dB d'atténuation des ondes électromagnétiques) en fonction du pas d des mailles et de la longueur d'onde $\lambda$ de ces ondes (si le diamètre du fil constituant les mailles est faible par rapport à leur pas) :

$$EB = 20 \log \lambda/2d.$$

Selon un exemple de réalisation de l'invention, la grille est à mailles rectangulaires et constituées de fils de cuivre d'un diamètre d'environ 25 $\mu$m et d'un pas d'environ 200 $\mu$m; mais il est bien entendu que ces paramètres de la grille peuvent avoir d'autres valeurs en fonction de l'efficacité recherchée, de la longueur d'onde des ondes parasites susceptibles de se manifester pendant toute la durée d'utilisation de l'écran, et des fils dont on dispose.

Comme représenté en figure unique, la grille métallique 1 est soudée à un cadre métallique 2 de forme et de dimensions correspondant à celles de l'ouverture du boîtier de l'écran à blinder. Ce cadre 2 a une hauteur de quelques millimètres par exemple. La surface de la grille 1 est plus grande que celle de l'ouverture du cadre 2, ce qui permet de souder facilement le pourtour de la grille 1 sur le cadre 2. Ce soudage peut se faire de différentes façons, par exemple soit un soudage continu par ultrasons, soit un soudage par décharge d'un condensateur, soit encore un soudage en continu à l'aide d'un flux à l'étain.

Le cadre 2 est fixé, par exemple par vissage, à l'intérieur du boîtier 3 renfermant l'écran 4 à cristaux liquides. Le cadre 2 est ainsi en contact électrique direct avec le boîtier 3.

L'écran 4 est disposé à l'intérieur du boîtier 3, et est visible à travers une ouverture 5 formée dans ce boîtier. Le boîtier 3 peut être le boîtier d'origine de l'écran ou une structure mécanique appropriée, par exemple celle d'un appareil dans lequel est disposé cet écran. Le rebord 6 du boîtier bordant l'ouverture 5 est dirigé vers l'écran 4 et se termine par une face plane 7 parallèle à l'écran 4 qui est légèrement en retrait (de quelques mm) de cette face 7.

Afin de garantir une parfaite planéité et une parfaite tension de la grille 1, on la tend pendant le soudage à l'aide d'un outillage approprié. Pour appliquer cette tension, on prend une grille plus grande que le cadre, on serre ses bords à l'aide dudit outillage et on applique une tension sur tous les bords de la grille avec cet outillage. Bien entendu, après soudage, on coupe la partie de la grille dépassant du cadre.

Pour améliorer la tension de la grille, on contraint le cadre par une pression appliquée sur ses côtés et dirigée vers l'extérieur du cadre. Après soudage, la contrainte appliquée au cadre est relâchée, et celui-ci, par effet d'élasticité, tend la grille.

Après soudage de la grille sur le cadre, on peut avantageusement noircir la grille, afin d'éviter toutes réflexions parasites sur les fils de la grille.

Selon un aspect avantageux de l'invention, pour protéger non seulement la grille, mais également le contenu du boîtier 3 des agressions mécaniques et/ou chimiques extérieures, on fixe un film 8 de protection, par exemple un film de matériau plastique polymère devant la face antérieure de la grille1. Ce film est serré entre la face 7 du rebord 6 et la grille 1.

Ainsi, grâce au dispositif de l'invention, on obtient un blindage présentant une parfaite reprise de continuité électrique entre la grille métallique et la structure métallique de l'appareil renfermant l'écran, ce qui permet de satisfaire les normes CEM et EMI civiles et militaires en vigueur. Ce dispositif de blindage présente une épaisseur minimale, ce qui permet d'avoir un boîtier 3 de faible épaisseur. En outre, ce dispositif présente une transparence optimisée (pouvant dépasser 75%) ne diminuant que très peu la luminosité de l'écran.

La réalisation de l'ensemble cadre-grille décrit ci-dessus, assure une tension et une planéité de la grille métallique de bonne qualité, ce qui permet d'éliminer les phénomènes de moirage dus à sa superposition avec l'écran.

L'encombrement du dispositif est minimal (le rebord 6 est de faible profondeur, et l'épaisseur du cadre 2 est également faible).

De plus, le dispositif de l'invention, outre sa fonction de blindage électromagnétique, offre des possibilités de protection, en particulier contre les rayons ultraviolets, les agents chimiques, les chocs et les rayures.

Bien entendu, on peut adjoindre au film 8 des filtres améliorant les contrastes.

## Revendications

1. Dispositif de blindage EMI/CEM rigide pour appareillage électronique disposé dans un boîtier métallique (3) ou métallisé comportant une ouverture (5), **caractérisé en ce qu'**il comporte une grille métallique (1) fixée à un cadre métallique (2), ce cadre étant fixé derrière l'ouverture du boîtier.

2. Dispositif selon la revendication 1, **caractérisé en ce que** la fixation de la grille sur le cadre est faite par soudage.

3. Dispositif selon la revendication 2, **caractérisé en ce que** le soudage est l'un des soudages suivants : soudage continu par ultrasons, soudage par décharges d'un condensateur, soudage en continu à l'aide d'un flux à l'étain.

4. Dispositif selon l'une des revendications précédentes, **caractérisé en ce que** la grille est tendue lors de sa fixation sur le cadre.

5. Dispositif selon l'une des revendications précédentes, **caractérisé en ce que** le cadre est contraint lors de la fixation de la grille.

6. Dispositif selon l'une des revendications précédentes, **caractérisé en ce qu'**il comporte un film plastique (8) devant la grille.

| | Office européen des brevets | **RAPPORT DE RECHERCHE EUROPEENNE** | Numéro de la demande EP 01 40 2720 |

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| A | FR 2 202 858 A (DELOG DETAG FLACHGLAS AG) 10 mai 1974 (1974-05-10) * page 3, ligne 15 - page 4, ligne 6; figures 1,2 * | 1-6 | H05K9/00 |
| A | WO 96 06520 A (GORE & ASS) 29 février 1996 (1996-02-29) * page 3, ligne 29 - page 4, ligne 4; figure 1 * | 1-6 | |
| A | EP 0 908 920 A (BRIDGESTONE CORP) 14 avril 1999 (1999-04-14) * colonne 7, ligne 6 - ligne 22; figure 1 * | 1-6 | |
| A | WO 98 59335 A (VIRATEC THIN FILMS INC) 30 décembre 1998 (1998-12-30) * page 5, ligne 23 - page 6, ligne 10; figure 1 * | 1-6 | |
| A | FR 2 781 789 A (SAINT GOBAIN VITRAGE) 4 février 2000 (2000-02-04) * page 7, ligne 19 - ligne 24; figure 1 * | 1-6 | DOMAINES TECHNIQUES RECHERCHES (Int.Cl.7) H05K |

Le présent rapport a été établi pour toutes les revendications

| Lieu de la recherche LA HAYE | Date d'achevement de la recherche 20 décembre 2001 | Examinateur Rubenowitz, A |

**ANNEXE AU RAPPORT DE RECHERCHE EUROPEENNE
RELATIF A LA DEMANDE DE BREVET EUROPEEN NO.**

EP 01 40 2720

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

20-12-2001

| Document brevet cité au rapport de recherche | | Date de publication | Membre(s) de la famille de brevet(s) | | Date de publication |
|---|---|---|---|---|---|
| FR 2202858 | A | 10-05-1974 | BE | 805052 A1 | 16-01-1974 |
| | | | CH | 589569 A5 | 15-07-1977 |
| | | | FR | 2202858 A1 | 10-05-1974 |
| | | | IT | 996295 B | 10-12-1975 |
| | | | NL | 7313214 A ,B | 16-04-1974 |
| WO 9606520 | A | 29-02-1996 | AU | 7979394 A | 14-03-1996 |
| | | | WO | 9606520 A1 | 29-02-1996 |
| EP 0908920 | A | 14-04-1999 | JP | 11119674 A | 30-04-1999 |
| | | | JP | 11119667 A | 30-04-1999 |
| | | | JP | 11119668 A | 30-04-1999 |
| | | | JP | 11119669 A | 30-04-1999 |
| | | | JP | 11119670 A | 30-04-1999 |
| | | | JP | 11119671 A | 30-04-1999 |
| | | | JP | 11119672 A | 30-04-1999 |
| | | | JP | 11119666 A | 30-04-1999 |
| | | | JP | 11119673 A | 30-04-1999 |
| | | | EP | 0908920 A2 | 14-04-1999 |
| | | | US | 6255778 B1 | 03-07-2001 |
| WO 9859335 | A | 30-12-1998 | AU | 8166198 A | 04-01-1999 |
| | | | EP | 0992032 A1 | 12-04-2000 |
| | | | WO | 9859335 A1 | 30-12-1998 |
| FR 2781789 | A | 04-02-2000 | FR | 2781789 A1 | 04-02-2000 |

EPO FORM P0460

Pour tout renseignement concernant cette annexe : voir Journal Officiel de l'Office européen des brevets, No.12/82